Europäisches Patentamt

**European Patent Office**

Office européen des brevets

(19)

(11) Publication number: **0 227 028 B1**

(12) EUROPEAN PATENT SPECIFICATION

(45) Date of publication of patent specification: **12.08.92**   (51) Int. Cl.⁵: **H05K 7/14**, G05B 19/08

(21) Application number: **86117571.9**

(22) Date of filing: **17.12.86**

(54) **Program controller.**

(30) Priority: **25.12.85 JP 290333/85**

(43) Date of publication of application:
**01.07.87 Bulletin 87/27**

(45) Publication of the grant of the patent:
**12.08.92 Bulletin 92/33**

(84) Designated Contracting States:
**DE GB NL SE**

(56) References cited:
**EP-A- 0 075 945**
**US-A- 4 558 914**

(73) Proprietor: **MITSUBISHI DENKI KABUSHIKI KAISHA**
**2-3, Marunouchi 2-chome Chiyoda-ku**
**Tokyo 100(JP)**

(72) Inventor: **Takahashi, Noboru MITSUBISHI DE-NKI K.K.**
**Nagoya Works, 1-14, Yada Minami**
**5-chome Higashi-ku Nagoya-shi Aichi(JP)**

(74) Representative: **Eisenführ, Speiser & Partner**
**Martinistrasse 24**
**W-2800 Bremen 1(DE)**

## Description

This invention relates to a program controller for controlling units to be controlled (hereafter referred to as loads) in accordance with programs pre-inputted from peripheral units through a central processing unit (hereafter referred to as CPU), and more specifically to a program controller comprising a plurality of sequencer units provided with input terminals and output terminals on the surface side of a case, wherein working signals are inputted from external input units through said input terminals, and said loads are controlled through the output terminals in accordance with said programs.

From US-A-4558914, it is known a program controller comprising input/output modules which incorporate post means formed thereon and slider means connected thereto and movable into and out of locking engagement with the post means of an adjacent module. Thus, a unit input/output module is achieved which is rapidly mounted to an adjacent module as well as rapidly disconnected therefrom. Preferably, each input/output module incorporates mating connectors positioned on opposite surfaces thereof, whereby each input/output module electronically directly connects to an adjacent module for communication with a central processor.

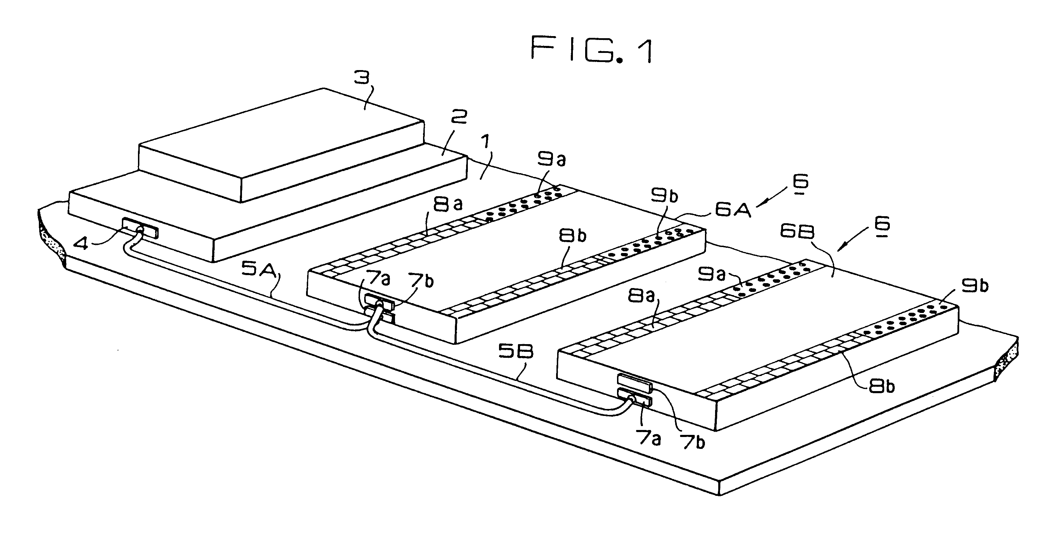

A further conventional program controller composed of CPU, peripheral units, sequencer units, external input units, loads, etc. as described above has been heretofore constructed for example as shown in FIG. 1. FIG. 1 is a perspective view showing a conventional program controller. In FIG. 1, CPU 2 is provided on the surface of a substrate 1, and above the CPU 2 is provided a peripheral unit 3 having a predetermined program. An output terminal 4 is provided on the end on the case side of the CPU 2, and one end of a cable 5A is connected to the output terminal 4. A plurality of sequencer units 6 are provided on the substrate 1 and in the position parallel to the CPU 2, and the other end of the cable 5A is connected to a connection terminal 7a provided on the end on the case side of a sequencer unit 6A in the close proximity of CPU 2. The sequencer unit 6A and a sequencer unit 6B provided parallel to the unit 6A are connected through connection terminals 7b and 7a and cable 5B. The sequencer unit 6 has, for example, a flat rectangular case, and on opposite side edges on the long sides of the case are provided input terminals 8a and output terminals 8b to which unshown external input units and loads are connected. Adjacent to the input terminals 8a of the sequencer units 6A and 6B are provided input displays 9a which display the inputs to the respective terminals. Corresponding to the input displays 9a and adjacent to the output terminals 8b are provided output displays 9b which display the output state from the respective terminals.

The step of assembling the aforementioned program controller will be described.

First, CPU 2 with the peripheral unit 3 placed thereon, sequencer units 6A and 6B are secured at fixed intervals onto one surface of the substrate 1. In this case, the sequencer unit 6 is secured in a position (for example, located to be above in the illustrated state) so that the input and output terminals 8a and 8b of the sequencer units 6A and 6B are not shielded by the substrate 1 or other units. Next, the terminal 4 and the terminal 7a of the sequencer unit 6A are connected by the cable 5A, and the terminal 7b of the sequencer unit 6A and the terminal 7a of the sequencer unit 6B are connected by the cable 5B. Finally, external input units and loads (both are not shown) are connected to the input termianls 8a and output terminals 8b of the sequencer units 6A and 6B, respectively.

The thus assembled program controller controls loads (not shown) in accordance with the programs preinputted into the CPU 2 by the peripheral unit. In this control, the sequencer unit 6 inputs working signals of the external input units (not shown) from the input terminals 8a thereof, outputs said working signals to the CPU 2, where a required processing is carried out, and thereafter receives instruction signals to the loads from the CPU 2, and sends the instruction signals to the loads (not shown) through the output terminals 8b.

However, according to the above-mentioned program controller, the sequencer units 6 are formed to have the same shape and same dimension. Therefore, in mounting the sequencer units 6A and 6B on the substrate 1, they have to be arranged parallel to each other on the plane. This poses a problem in that the actual mounting efficiency of the sequencer units 6 to the substrate 1 is poor. That is, if for example, the sequencer units 6 are laminated and mounted on the substrate 1, the input terminals 9a and output terminal 8b of the lower sequencer unit 6 are shielded by the bottom surface of the case for the upper sequencer unit 6, resulting in a problem in that the external input units and loads (which are not shown) cannot be connected.

It is an object of the present invention to provide a program controller in which sequencer units are laminated and mounted on a mounting surface of a substrate, whereby components may be installed on the substrate with high packaging density.

It is another object of the invention to provide a program controller in which even if sequencer units are laminated and mounted on a substrate, external input units and loads may be connected to the sequencer units so that input and output terminals provided on the surface on opposite side edges on the long side in a case for flat and rectangular sequencer units are not shielded by the bottom surface of the case for the upper sequencer unit.

In order to achieve the above objects, according to the invention, it is provided a program controller having a plurality of sequencer units each sequencer unit being encased within a case and provided with input terminals and output terminals along the opposite side edges of the upper surface of the respective case, and a central processing unit integral with a peripheral unit provided on the upper surface of the central processing unit, said peripheral unit outputting a predetermined program, said sequencer units and central processing unit being mounted on a substrate, the cases of the sequencer units being sequentially different in the width dimension by a width portion corresponding to the width of said input terminal plus said output terminal, the cases of the sequencer units being stackable in a multi-stage fashion while being sequentially laminated and arranged according to their different width dimension, the narrower cases being stacked on wider cases thereby permitting the connection of external input units and loads to the stacked sequencer units, said central processing unit being mounted between said input and output terminals arranged on the opposite side edges of the surface of the uppermost of said cases having a suitable dimension of width.

In the program controller of the present invention, the dimension of the cases for the sequencer units are differentiated, particularly a width of a case is narrowed through a portion corresponding to a width of input and output terminals whereby the sequencer units may be laminated and mounted on a substrate, and external input units and loads may be connected to the stacked sequencer units.

Further advantageous embodiments are defined in the subclaims.

In the following, advantageous embodiments of the invention are described with reference to the accompanying figures, in which:

FIG. 1 is a fragmentary perspective view showing one example of a conventional program controller in which a plurality of sequencer units, CPU and the like are mounted on a substrate in a parallel fashion;

FIG: 2 is an exploded perspective view of one embodiment of a program controller according to the present invention, showing the state wherein CPU is mounted on a substrate, said CPU being stacked on one of sequencer units; and

FIG. 3 is an exploded perspective view of another embodiment of a program controller according to the present invention, showing the state wherein a plurality of sequencer units and CPU encased within cases of different width are laminated in a multi-stage fashion and mounted on a substrate.

DETAILED DESCRIPTION OF THE PREFERRED EMBODIMENTS

Preferred embodiments of a program controller according to the present invention will be described in detail with reference to the drawings.

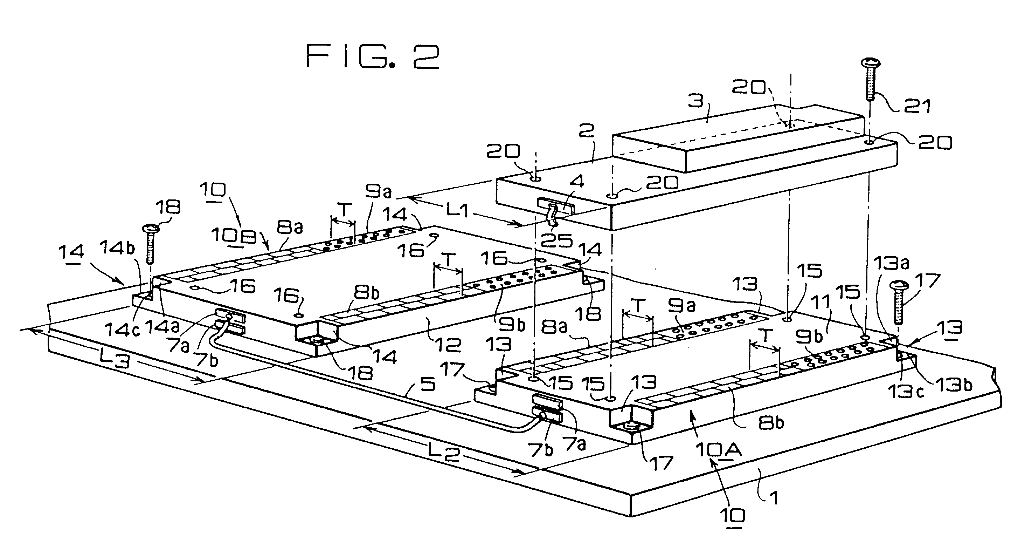

FIG. 2 shows one embodiment of the present invention, in which figure, parts indicated by the same numerals as those of FIG. 1 represent the same or corresponding parts, and a duplicate explanation will not be made. In FIG. 2, a plurality of sequencer units 10 are mounted on a substrate 1. The sequencer units 10 comprise a sequencer unit 10A encased in a flat, rectangular and narrow case 12 and a sequencer unit 10B encased in a flat and rectangular but slightly narrower (than that of the case 12) case 11. On opposite side edges on the upper surface on the long side of the cases 11 and 12 for the sequencer units 10A and 10B having the respective widths are provided an input terminal 8a, an output terminal 8b, an input display 9a and an output display 9b. Formed at four corners of the cases 11 and 12 are notches 13a and 14a to form mounting plates 13b and 14b, which are formed with holes 13c and 14c, respectively. These elements constitute mounting portions 13 and 14 used to lock the cases 11 and 12 including the substrate 1 to one another. Terminals 7a and 7b are provided on the end on the short side of the cases 11 and 12. Reference numeral denotes a CPU comprising a peripheral unit 3 mounted on the upper portion, a terminal 4 at the end on the short side and mounting holes 20 at four corners thereof. The cases 11 and 12 are also formed at suitable positions with mounting holes 15 and 16. Here, the width L2 of the narrow case 11 corresponds to the width obtained by adding the width 2T of the input and output terminals 8a and 8b to the width L1 of CPU 2. The width L3 of the wide case 12 corresponds to the width obtained by adding the width 2T of the input and output terminals 8a and 8b to the width L2 of the narrow case 11. The position of the mounting hole 20 to be bored corresponds to that of the mounting hole 15, and the position of the hole 13c to be bored of the mounting portion 13 corresponds to that of the mounting hole 16.

The components having the above-described basic structures may be mounted on the substrate 1 in the following procedure. In the embodiment shown in FIG. 2, the sequencer units 10A and 10B are secured parallel to each other on the mounting surface of the substrate 1, and the CPU 2 is mounted on the sequencer unit 10A encased in the narrow case 11 whereby a program controller is assembled. In mounting, first, the respective sequencer units 10A and 10B are positioned on the substrate 1, mounting screws 17 and 18 are screwed into the holes 13c and 14c of the mounting portions 13 and 14 of the cases 11 and 12, respectively, and the cases 11 and 12 are secured to the substrate 1. Then, the terminal 7b of the sequencer unit 10B encased in the narrow case 11 and the terminal 7a of the sequencer unit 10B encased in the wide case 12 are connected by the cable 5. Finally, the CPU 2 integral with the peripheral unit 3 is positioned in the central portion of the upper surface of the narrow case 11, that is, in the position not to block the input and output terminals 8a and 8b on the opposite sides, the mounting hole 20 is made to correspond to the mounting hole 15, four corners of the CPU 2 are secured to the upper surface of the case 11 by means of mounting screws 21, and the terminal 4 of CPU 2 and the terminal 7a of sequencer unit 10A are connected by means of a connector 25. In this way, installation of the components of the program controller and electric connection will be completed. External input units and loads (not shown) are respectively connected to the input and output terminals 8a and 8b of the sequencer units 10A and 10B, respectively.

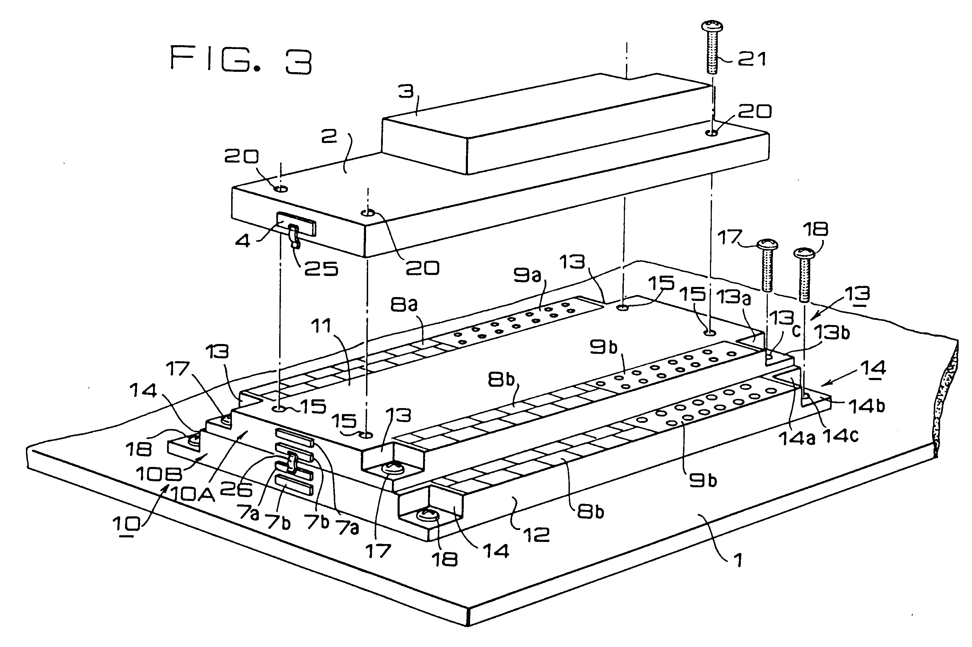

While in the above-described embodiment, the case has been described in which the sequencer units 10A and 10B encased in the cases 11 and 12, respectively, different in width from each other are provided parallel to each other on the substrate 1, it should be noted that in this invention, the sequencer units 10A and 10B may be laminated on and secured to the substrate 1 as shown in another embodiment illustrated in FIG. 3. The construction of components of the sequencer units 10A and 10B and CPU 2 is generally the same as that of FIG. 1.

In another embodiment shown in FIG. 3, the sequencer unit 10B encased in the wide case 12 is first positioned to the mounting surface of the substrate 1, the mounting portions 4 at four corners are screwed into the substrate 1 by means of mounting screws 18, and the sequencer unit 10B is then fixed. Next, the sequencer unit 10A encased in the narrow case 11 is placed on the wide case 12 of the sequencer unit 10B, and the case 11 is positioned on the case 12 in a manner so as not to block the input and output terminals 8a, 8b and the input and output displays 9a, 9b of the sequencer unit 10B, after which both are integrally fixed by means of mounting screws 17 which extend through the hole 13c of the mounting portion 13 and the hole 16 of the case 12. Finally, the CPU 2 integral with the peripheral unit 3 is placed on the upper surface of the case 11, the mounting hole 20 is placed in registration with the mounting hole 15, and the CPU 2 is secured to the sequencer unit 10A by means of a screw 21. Electric connection between the CPU 2 and the sequencer unit 10A is done by means of a connector 25 in a manner similar to the embodiment shown in FIG. 2 but electric connection between the sequencer 10A and 10B is done by means of a connector 26.

While in the above-described embodiments, two sequencer units 10 are provided; they are fixed parallel to each other in one embodiment, and they are laminated in the other, it is to be noted in this invention that the sequencer units are not limited to two in the number but the n number of sequencer units which sequentially increase in width through 2T are prepared to thereby provide a program controller provided with sequencer units laminated or stacked in the n-stages. In addition, the m-rows of sequencer units capable of being laminated in the n-stages may be prepared to thereby incorporate n x m sequencer units with high packaging density.

While in the above-described embodiments, the sequencer units 10A, 10B and CPU 2 have been secured to one another by means of mounting screws 17, 18 and 21, it is to be further that the present invention is not limited thereto but these may be integrally adhered to by adhesives or dual adhesive tapes or the like. Where the components have to be removed from the substrate 1 or relocated in their mounting position whenever necessary, engaging mechanisms may be formed in the joining surfaces of the cases for two sequencer units which are in the respective laminating positional relation, other than the use of the mounting screws as in the aforementioned embodiments, and said engaging mechanisms are brought into engagement to have the sequencer units integrated.

As described in detail above, according to the program controller of the present invention, the sequencer units and CPU may be sequentially laminated without blocking the input and output terminals provided on the opposite side edges on the surface of many sequencer units. Therefore, the packaging density when the sequencer units are mounted on the substrate may be satisfactorily increased.

Furthermore, even when the sequencer units are laminated in a multi-stage fashion, the input terminals, output terminals and input and output displays are not blocked by the bottom surface of the case for the upper sequencer unit. Therefore, it is possible to provide a program controller capable of connecting external input units and loads to the input terminals and output terminals.

Moreover, where the components such as sequencer units and CPU are desired to be flatly secured to the mounting surface of the substrate, they can be also secured parallel to each other on the mounting surface of the substrate. Therefore, it is possible to provide a program controller of a thin type as desired.

## Claims

1. A program controller having a plurality of sequencer units (10A, B) each sequencer unit (10A, B) being encased within a case (11, 12) and provided with input terminals (8a) and output terminals (8b) along the opposite side edges of the upper surface of the respective case, and a central processing unit (2) integral with a peripheral unit (3) provided on the upper surface of the central processing unit (2), said peripheral unit (3) outputting a predetermined program, said sequencer units (10A, B) and central processing unit (2) being mounted on a substrate (1), the cases (11, 12) of the sequencer units (10A, B) being sequentially different in the width dimension (L2, L3) by a width portion corresponding to the width (2T) of said input terminal (8a) plus said output terminal (8b), the cases (11, 12) of the sequencer units (10A, B) being stackable in a multi-stage fashion while being sequentially laminated and arranged according to their different width dimension (L2, L3), the narrower cases (11) being stacked on wider cases (12), thereby permitting the connection of external input units and loads to the stacked sequencer units (10A, B), said central processing unit (2) being mounted between said input and output terminals (8a, b) arranged on the opposite side edges of the surface of the uppermost (11) of said cases (11,12) having a suitable dimension of width (L2).

2. The program controller as defined in claim 1, wherein the cases (11, 12) different in dimension of width (L2, L3) which encase said sequencer units (10A, B) are each formed into a flat rectangular shape, and provided with said input and output terminals (8a, b) along the opposite side edges of the upper surface.

3. The program controller as defined in claim 1, wherein the cases (11, 12) different in dimension of width (L2, L3) which encase said sequencer units (10A, B) are laminated and secured in a multi-stage fashion to the mounting substrate (1), and the bottom surface of the upper case (11) is located betweeen said input and output terminals (8a, b) on the opposite side edges on the upper surface of the lower case (12).

4. The program controller as defined in claim 1, wherein said plurality of cases (11, 12) for said sequencer units (10A, B) are fixed while being sequentially laminated.

5. The program controller as defined in claim 1, wherein said sequencer units (10A, B) encased in said plurality of cases (11, 12) formed to have a different dimension in width (L2, L3) are secured parallel to each other to the mounting surface of the substrate (1).

6. The program controller as defined in claim 1, wherein among said cases (11, 12) different in dimension of width (L2, L3), the case (11) having a suitable dimension of width (L2) has said central processing unit (2) placed on and secured to the upper surface thereof, said central processing unit (2) being positioned between the input and output terminals (8a, b) of said case (11).

7. The program controller as defined in claim 1, wherein said sequencer units (10A, B) encased in the cases (11, 12) having the respective dimensions of width (L2, L3) are electrically connected to each other.

8. The program controller as defined in claim 1, wherein external input units are connected to said input terminals (8a) of said sequencer units (10A, B) and loads as the outputs are connected to said output terminals (8b).

9. The program controller as defined in claim 1, wherein each of said cases (11, 12) for said sequencer units (10A, B) is secured to said substrate (1) or to the upper surface of the lower case (12) directly close thereto by means of mounting screws (17, 18).

10. The program controller as defined in claim 1, wherein each of said cases (11, 12) for said sequencer units (10A, B) is secured to said substrate (1) or to the upper surface of the lower case (12) directly close thereto by adhesive means.

## Revendications

1. Contrôleur d'exécution de programme, comportant une pluralité d'éléments de séquenceur (10A, B), chaque élément de séquenceur (10A, B) étant enfermé dans un boîtier (11, 12) et muni de bornes d'entrée (8a) et de bornes de sortie (8b) le long des bords latéraux opposés de la surface supérieure du boîtier respectif, et une unité centrale de traitement (2) formant une pièce avec un unité périphérique (3) prévue sur la surface supérieure de l'unité centrale de traitement (2), l'unité périphérique (3) sortant un programme prédéterminé, les éléments de séquenceur (10A, B) et l'unité centrale de traitement (2) étant montés sur un substrat (1), les boîtiers (11, 12) des éléments de séquenceur (10A, B) étant séquentiellement différents dans la dimension de largeur (L2, L3) d'une partie de largeur qui correspond à la largeur (2T) de la borne d'entrée (8a) plus la borne de sortie (8b), les boîtiers (11, 12) des éléments de séquenceur (10A, B) pouvant être empilés d'une façon à étages multiples tout en étant séquentiellement laminés et agencés suivant leur dimension différente de largeur (L2, L3), les boîtiers plus étroits (11) étant empilés sur des boîtiers plus larges (12), permettant par cela la connexion d'éléments d'entrées externes et de charges aux éléments de séquenceur empilés (10A, B), l'unité centrale de traitement (2) étant montée entre lesdites bornes d'entrée et de sortie (8a, b) agencées sur les bords latéraux opposés de la surface du plus élevé (11) desdits boîtiers (11, 12) qui a une dimension appropriée en largeur (L2).

2. Contrôleur d'exécution de programme suivant la revendication 1, caractérisé en ce que les boîtiers (11, 12) qui diffèrent dans la dimension de la largeur (L2, L3) et qui enferment les éléments de séquenceur (10A, B) sont chacun formés en une forme rectangulaire plate et munis desdites bornes d'entrée et de sortie (8a, b) le long des bords latéraux opposés de la surface supérieure.

3. Contrôleur d'exécution de programme suivant la revendication 1, caractérisé en ce que les boîtiers (11, 12) qui diffèrent dans la dimension de la largeur (L2, L3) et qui enferment les éléments de séquenceur (10A, B) sont laminés et fixés d'une façon à étages multiples sur le substrat de montage (1), et en ce que la surface de base du boîtier supérieur (11) est située entre les bornes d'entrée et de sortie (8a, b) des bords latéraux opposés de la surface supérieure du boîtier inférieur (12).

4. Contrôleur d'exécution de programme suivant la revendication 1, caractérisé en ce que la pluralité de boîtiers (11, 12) des éléments de séquenceur (10A, B) sont fixés tout en étant séquentiellement laminés.

5. Contrôleur d'exécution de programme suivant la revendication 1, caractérisé en ce que les éléments de séquenceur (10A, B) enfermés dans la pluralité de boîtiers (11, 12) qui sont formés pour avoir une dimension différente en largeur (L2, L3) sont fixés parallèlement l'un à l'autre sur la surface de montage du substrat (1).

6. Contrôleur d'exécution de programme suivant la revendication 1, caractérisé en ce que parmi lesdits boîtiers (11, 12) qui diffèrent dans la dimension de la largeur (L2, L3), le boîtier (11) qui présente une dimension de largeur (L2) appropriée a l'unité centrale de traitement (2) qui est placée sur et fixée à sa surface supérieure, l'unité centrale de traitement (2) étant positionnée entre les bornes d'entrée et de sortie (8a, b) dudit boîtier (11).

7. Contrôleur d'exécution de programme suivant la revendication 1, caractérisé en ce que les éléments de séquenceur (10A, B) enfermés dans les boîtiers (11, 12) qui présentent les dimensions respectives de largeur (L2, L3) sont raccordés électriquement l'un à l'autre.

8. Contrôleur d'exécution de programme suivant la revendication 1, caractérisé en ce que les éléments d'entrées externes sont raccordés aux bornes d'entrée (8a) des éléments de séquenceur (10A, B) et en ce que des charges, en tant que sorties, sont raccordées aux bornes de sortie (8b).

9. Contrôleur d'exécution de programme suivant la revendication 1, caractérisé en ce que chacun des boîtiers susdits (11, 12) des éléments de séquenceur (10A, B) est fixé au moyen de vis de montage (17, 18) au substrat (1) ou à la surface supérieure du boîtier inférieur (12) qui en est directement proche.

10. Contrôleur d'exécution de programme suivant la revendication 1, caractérisé en ce que chacun des boîtiers susdits (11, 12) des éléments de séquenceur (10A, B) est fixé par des moyens adhésifs au substrat (1) ou à la surface supérieure du boîtier inférieur (12) qui en est directement proche.

**Patentansprüche**

1. Programmcontroller mit mehreren Zuordnungseinheiten (10A, B), wobei jede Zuordnungseinheit (10A, B) in einem Gehäuse (11, 12) eingeschlossen ist und mit Eingangsanschlüssen (8a) und Ausgangsanschlüssen (8b) entlang der gegenüberliegenden Seitenränder der oberen Fläche des entsprechenden Gehäuses versehen sind, und einer Zentralprozessoreinheit (2), die mit einer Peripherieeinheit (3) einstük-

kig verbunden ist, die an der oberen Fläche der Zentralprozessoreinheit (2) vorgesehen ist, wobei die Peripherieeinheit (3) ein bestimmtes Programm ausgibt, wobei die Zuordnungseinheiten (10A, B) und die Zentralprozessoreinheit (2) auf einem Substrat (1) befestigt sind, die Gehäuse (11, 12) der Zuordnungseinheiten (10A, B) der Reihe nach in der Breitenabmessung (L2, L3) um einen Breitenabschnitt entsprechend der Breite (2T) des Eingangsanschlusses (8a) plus dem Ausgangsanschluß (8b) unterschiedlich sind, die Gehäuse (11, 12) der Zuordnungseinheiten (10A, B) in mehrstufiger Anordnung übereinander stapelbar sind, während sie der Reihe nach geschichtet und entsprechend ihrer unterschiedlichen Breitenabmessung (L2, L3) angeordnet sind, die schmaleren Gehäuse (11) auf den breiteren Gehäusen (12) gestapelt sind, wodurch ein Anschluß von externen Eingabeeinheiten und Lasten an die gestapelten Zuordnungseinheiten (10A, B) möglich ist, die Zentralprozessoreinheit (2) zwischen den Eingangs- und Ausgangsanschlüssen befestigt ist, welche an den gegenüberliegenden Seitenrändern der Oberfläche des obersten (11) der Gehäuse (11, 12) mit einer geeigneten Abmessung der Breite (L2) angeordnet sind.

2. Programmcontroller nach Anspruch 1, bei welchem die in der Abmessung der Breite (L2, L3) unterschiedlichen Gehäuse (11, 12), die die Zuordnungseinheiten (10A, B) einschließen, jeweils in einer flachen Rechteckform geformt und mit den Eingangs- und Ausgangsanschlüssen (8a, b) entlang der gegenüberliegenden Seitenränder der oberen Oberfläche versehen sind.

3. Programmcontroller nach Anspruch 1, bei welchem die in der Abmessung der Breite (L2, L3) unterschiedlichen Gehäuse (11, 12), die die Zuordnungseinheiten (10A, B) einschließen, am Befestigungssubstrat (1) in mehrstufiger Anordnung geschichtet und befestigt sind und die Bodenfläche des oberen Gehäuses (11) zwischen den Eingangs- und Ausgangsanschlüssen (8a, b) an den gegenüberliegenden Seitenrändern auf der oberen Oberfläche des unteren Gehäuses (12) liegt.

4. Programmcontroller nach Anspruch 1, bei welchem die mehreren Gehäuse (11, 12) für die Zuordnungseinheiten (10A, B) befestigt sind, während sie der Reihe nach übereinander geschichtet sind.

5. Programmcontroller nach Anspruch 1, bei welchem die Zuordnungseinheiten (10A, B), die in den mehreren Gehäusen (11, 12) eingeschlossen sind, welche mit unterschiedlichen Abmessungen in der Breite (L2, L3) ausgebildet sind, parallel zueinander an der Befestigungsfläche des Substrats (1) befestigt sind.

6. Programmcontroller nach Anspruch 1, bei welchem von den in der Abmessung der Breite (L2, L3) unterschiedlichen Gehäusen (11, 12) auf der oberen Fläche des Gehäuses (11) mit einer geeigneten Abmessung der Breite (L2) die Zentralprozessoreinheit (2) angeordnet und befestigt ist, wobei die Zentralprozessoreinheit (2) zwischen den Eingangs- und Ausgangsanschlüssen (8a, b) des Gehäuses (11) liegt.

7. Programmcontroller nach Anspruch 1, bei welchem die Zuordnungseinheiten (10A, B), die in den Gehäusen (11, 12) mit den entsprechenden Abmessungen der Breite (L2, L3) enthalten sind, elektrisch miteinander verbunden sind.

8. Programmcontroller nach Anspruch 1, bei welchem externe Eingabeeinheiten an den Eingangsanschlüssen (8a) der Zuordnungseinheiten (10A, B) und Lasten als Ausgänge an den Ausgangsanschlüssen (8b) angeschlossen sind.

9. Programmcontroller nach Anspruch 1, bei welchem jedes der Gehäuse (11, 12) für die Zuordnungseinheiten (10A, B) am Substrat (1) oder an der oberen Fläche des unteren Gehäuses (12) direkt dicht bei diesem mittels Befestigungsschrauben (17, 18) befestigt ist.

10. Programmcontroller nach Anspruch 1, bei welchem jedes der Gehäuse (11, 12) für die Zuordnungseinheiten (10A, B) am Substrat (1) oder an der oberen Fläche des unteren Gehäuses (12) direkt dicht bei diesem mittels Klebemittel befestigt ist.

FIG.1

FIG. 2

EP 0 227 028 B1

FIG. 3